# EUROPÄISCHE PATENTANMELDUNG

(11) **EP 0 783 108 A1**
(43) Veröffentlichungstag der Anmeldung: **09.07.1997**
(21) Anmeldenummer: 96120429.4
(22) Anmeldetag: 18.12.1996
(51) Int. Cl.: G01P 15/08, G01P 1/02

(54) **Mikromechanisches Bauteil mit planarisiertem Deckel auf einem Hohlraum und Herstellverfahren**

(30) Priorität: 08.01.1996 DE 19600400
(71) Anmelder: SIEMENS AKTIENGESELLSCHAFT, 80333 München (DE)
(72) Erfinder: Werner, Wolfgang, Dr.-Ing., 81545 München (DE)

(57) **Zusammenfassung**

Bei einem mikromechanischen Bauteil mit einem Hohlraum (Ha, Hb) ist dieser mit einem gleichmäßig dicken Deckel (D), der eine Membranschicht (3) und eine Abdeckschicht (5) umfaßt, versehen. Das Verfahren sieht vor, die aus dotiertem Glas bestehende Abdeckschicht zu verfließen, wobei überraschenderweise die Abdeckschicht nicht in den Hohlraum hineinfließt, sondern einen an Ober- und Unterkante planen Deckel bildet. Es können mechanisch sehr stabile Deckel mit oder ohne Öffnung hergestellt werden. Das Verfahren ist kompatibel mit der Herstellung integrierter Schaltungen.

## Beschreibung

Die Erfindung betrifft ein mikromechanisches Bauteil auf einem Substrat mit einem Hohlraum, bei dem der Hohlraum mit einem Deckel versehen ist.

Mikromechanische Systeme, die aus einem mikromechanischen Bauteil und einer dazugehörigen integrierten Schaltung zum Beispiel zur Ansteuerung oder zur Auswertung auf demselben Substrat bestehen, sind von großem Interesse. Bei dem mikromechanischen Bauteil ist häufig eine Membran bzw. eine über einem Hohlraum angeordnete Deckschicht erforderlich. Diese Schicht kann sowohl eine passive Funktion als mechanischer Schutz übernehmen als auch als aktives Element dienen, beispielsweise als Elektrode einer Kapazität wirken oder andere elektrische Elemente beinhalten. Je nach Aufgabenstellung soll die Deckschicht entweder den Hohlraum vollständig dicht abschließen oder ihn durch eine definierte Öffnung in der Schicht mit der Umwelt verbinden. Ein Beispiel für den ersten Fall ist ein Drucksensor, für den zweiten Fall ein Tintenspritzer oder andere mikromechanische Düsen. In jedem Fall ist eine hohe mechanische Stabilität wichtig, unter anderem im Hinblick auf die Weiterverarbeitung und Montage des gesamten Systems in ein Gehäuse.

Zur Herstellung solcher Hohlräume ist aus der DE-Anmeldung Nr. 43 32 843 bekannt, auf ein Substrat eine Hilfsschicht und darauf eine mit Öffnungen versehene Membranschicht aufzubringen. Die Hilfsschicht wird durch die Öffnungen hindurch selektiv zur Membranschicht geätzt, so daß ein Hohlraum entsteht. Anschließend wird ein geeignetes Material aufgedampft oder aufgesputtert, wodurch die Öffnungen verschlossen werden. Derartig hergestellte Deckel besitzen aufgrund der schlechten Kantenbedeckung in jedem Fall große Dickenschwankungen, über den Öffnungen der Membranschicht ist die Schichtdicke sehr viel geringer. Dies führt zu schlechten mechanischen Eigenschaften, das heißt die Bruchfestigkeit der Schicht wird aufgrund der auftretenden Spannungspitzen an den dünnen Stellen der Abdeckung entsprechend gering.

Ein weiteres Verfahren, das in den Artikeln von K. Aratani et al., IEEE 1993 Nr. 0-7803-0957-2/93, Seite 230 und von Y Manoli et al., Microsystem, 1990, S. 710 beschrieben ist, besteht darin, eine mit einem Deckel versehene Siliziumoxid-Hilfsschicht durch dünne laterale Kanäle wegzuätzen und anschließend die Kanäle durch Abscheiden von Siliziumoxid oder Aluminium zu verschließen. Dadurch kann zwar ein wesentlich stabilerer Deckel hergestellt werden, das verfahren kann aber nur mit erheblichem Aufwand für die monolithische Integration des mikromechanischen Bauteils mit der integrierten Schaltung eingesetzt werden.

Aus dem Artikel von H. Elderstig et al., Sensors and Actuators A 46-47 (1995). S.95-97, ist bekannt, einen Hohlraum mit einem aufgeschleuderten Polymer zu verschließen. Durch das Vorhandensein des Polymers ist der Einsatzbereich beschränkt.

Aufgabe der vorliegenden Erfindung ist es, ein mikromechanisches Bauteil anzugeben, bei dem ein Hohlraum mit einem stabilen Deckel versehen ist und das für die Integration mit einer integrierten Schaltung in einem Mikrosystem geeignet ist. Weiter soll ein Herstellverfahren angegeben werden, das kompatibel mit der Herstellung von integrierten Schaltungen ist.

Diese Aufgabe wird durch ein mikromechanisches Bauteil mit den Merkmalen des Patentanspruchs 1 und durch ein Verfahren mit den Merkmalen des Patentanspruchs 8 gelöst.

Die Erfindung sieht vor, auf ein Substrat zunächst eine Hilfsschicht und eine mit einer oder mehreren Öffnungen versehene Membranschicht aufzubringen und in einem zur Membranschicht selektiven Ätzprozeß den Hohlraum in die Hilfsschicht zu ätzen. Dann wird eine Abdeckschicht vorgegebener Dicke aufgebracht und einem Temperaturschritt, d.h. einem Verfließprozeß, unterworfen. Nach diesem Schritt ist der Hohlraum mit einem Deckel von gleichmäßiger Schichtdicke verschlossen. Als Abdeckschicht wird ein dotiertes Glas (bspw. BPSG) in einem CVD-Verfahren aufgebracht und bei einer Temperatur von etwa 800 bis 1100°C verflossen.

Durch die Anordnung der Öffnungen in der Membranschicht läßt sich leicht jede gewünschte Form und Fläche des Hohlraums bzw. der Membran herstellen. Für die Herstellung von schmalen Kanälen als Hohlraum kann anstelle einer Lochreihe auch ein entsprechend langes Fenster in der Membranschicht verwendet werden, was dazu führt, daß die Seitenwände der Kanäle parallel zur Kanalrichtung ausgebildet werden.

Der Hohlraum kann auf einfache Weise mit einer oder mehreren Öffnungen versehen werden, in dem die Parameter y (= Dicke der Abdeckschicht) und x (= Durchmesser der Öffnung in der Membranschicht) geeignet gewählt werden. Für jeden Öffnungsdurchmesser x gibt es eine Schichtdicke y_{G} (Grenzschichtdicke), bei der die Öffnung nach dem Temperaturschritt geschlossen wird; bei Verwendung von dotiertem Glas ist vor dem Verfließen im allgemeinen noch ein kleiner Spalt vorhanden. Mit einer geringeren Schichtdicke y<y_{G} wird die Öffnung zwar verkleinert, aber nicht verschlossen, die Seitenwände werden verrundet. Umgekehrt werden bei vorgegebener Schichtdicke y Öffnungen mit einem Grenzdurchmesser x_{G} nach dem Verfließen gerade noch verschlossen, während größere Öffnungen (y>y_{G}) offenbleiben und nur verkleinert werden. Beispielsweise findet ab einem Durchmesser von ca. 1,5µm bei Verwendung einer 1 µm dicken BPSG-Schicht kein Verschließen beim Verfließprozeß statt. Die jeweiligen Werte für x_{G} oder y_{G} sind unter anderem von der Zusammensetzung der Abdeckschicht, also insbesondere der Dotierung eines Glases, und der Verfließtemperatur abhängig.

In den meisten Fällen wird ein Hohlraum mit ebener Oberfläche benötigt, so daß die Hilfschicht entsprechend plan hergestellt wird. Dann ist auch die Membranschicht eben und der Deckel planparallel. Der Hohlraum kann aber auch eine andere Form aufweisen, in dem beispielsweise ein Feldoxidgebiet vollständig weggeätzt wird. Die Membranschicht folgt der Oberfläche des Feldoxidgebietes, also auch den sogenannten Vogelschnäbeln, und der Deckel ist dann nicht planparallel, besitzt aber überall im wesentlichen die gleiche Dicke, insbesondere auch im Bereich der Öffnung in der Membranschicht.

Ferner ist es auch möglich, den Hohlraum mit einem im wesentlichen anisotropen Ätzprozeß in der Hilfsschicht herzustellen, so daß er sich praktisch nicht unter die Membranschicht erstreckt. Auch ein solcher Hohlraum kann mit dem erfindungsgemäßen Verfahren mit einem gleichmäßig dicken Deckel versehen werden (der direkt über dem Hohlraum eventuell nur aus der Abdeckschicht besteht), bzw. mit einem Deckel mit einer Öffnung versehen werden.

Je nach Einsatz des mikromechanischen Bauteils kann im Hohlraum eine bewegliche Struktur untergebracht sein, beispielsweise als Beschleunigungssensor oder eine feste Struktur. Der Hohlraum kann ebenso zur Aufnahme einer flüssigen oder gasförmigen Substanz dienen.

Die mit dem erfindungsgemäßen Verfahren hergestellten Deckel sind sehr stabil und halten auch den bei der Montage im Plastikgehäuse auftretenden Verpreßdrücken von bis zu 80 bar stand. Gleichzeitig erfolgt ihre Herstellung mit einem mit Halbleitertechnologien vollständig kompatiblen Verfahren, so daß Mikrosysteme problemlos herstellbar sind. Es muß lediglich berücksichtigt werden, daß der Deckel ggf. vor der Metallisierung der integrierten Schaltung hergestellt wird, da bei Verwendung von Aluminium als Metallisierung dieses nicht mehr den hohen Temperaturen beim Verfließprozeß ausgesetzt werden kann. Dies stellt aber im allgemeinen keine Einschränkung dar. Als Glas kann ein Bor- und/oder Phospor-dotiertes Siliziumdioxid verwendet werden, wie es in üblichen CMOS-Prozessen zur Planarisierung der Oberfläche eingesetzt wird. Der Bor- bzw. Phosphor-Gehalt liegt typischerweise zwischen 1% und 6%.

Zwar ist es in der Halbleitertechnologie bekannt, planare Schichten aus einem dotiertem Glas mit einem Verfließprozeß herzustellen. Die Anwendung dieses Verfahrens bei der hier gegebenen Situation ist aber nicht naheliegend, da erwartet wird, daß während des Temperaturschritts das Glas in den Hohlraum hineinfließt. Überraschenderweise ist dies nicht der Fall, sondern es bildet sich aufgrund von Oberflächeneffekten ein an der Oberkante und an der Unterkante planarer Deckel sowie eine dünne Schicht aus dotiertem Glas an den Wänden des Hohlraums, das heißt das Glas kriecht auch an der Unterseite der Membranschicht entlang.

Die Erfindung wird im folgenden anhand eines in den Zeichnungen dargestellten Ausführungsbeispiels näher erläutert. Es zeigen:

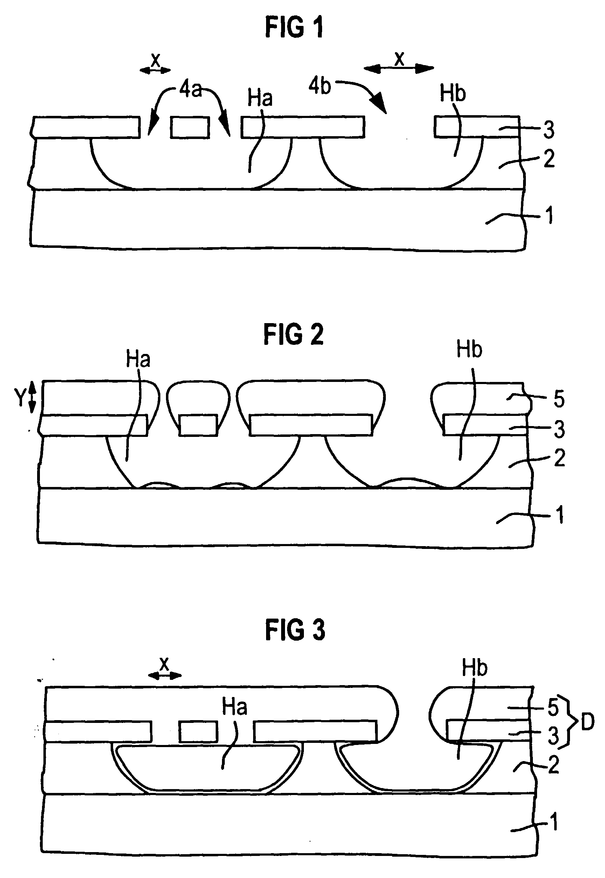

- Die Figuren 1 bis 3: einen Querschnitt durch eine Halbleitersubstrat im Bereich des mikromechanischen Bauteils, an den die Schritte des Verfahrens erläutert werden.

Figur 1: Auf einem aus Silizium bestehenden Halbleitersubstrat 1 ist eine aus Siliziumdioxid bestehende Hilfsschicht 2 von etwa 1µ Dicke und eine beispielsweise aus Polysilizium bestehende Membranschicht 3 aufgebracht. Die Membranschicht wurde mit Hilfe einer Fototechnik strukturiert, so daß sie Öffnungen 4 aufweist. Es existieren kleine Öffnungen 4a mit einem Durchmesser x<x_{G} und eine große Öffnung 4b mit einem Durchmesser x>x_{G}. Mit Hilfe eines isotropen Ätzprozesses wird nun die Hilfsschicht bis zum Substrat 1 geätzt, so daß ein Hohlraum Ha unterhalb der kleinen Öffnungen und ein Hohlraum Hb unterhalb der großen Öffnung 4b entstehen.

Figur 2: Mit einem üblichen Verfahren wird nun eine BPSG-Schicht 5 aufgebracht. Ihre Dicke ist so gewählt, daß über den kleinen Öffnungen 4a nach dem Abscheiden höchstens ein schmaler Spalt verbleibt, der durch das Verfließen sicher geschlossen wird, und gleichzeitig über der großen Öffnung 4b ein größerer Spalt verbleibt. Erkennbar wird auf dem Boden des Hohlraums Ha, Hb nur eine sehr geringe Menge des Glases abgeschieden.

Figur 3: Es wird ein Verfließprozeß bei beispielsweise 1000°C durchgeführt. Dadurch bildet sich über der ebenen Oberfläche des Hohlraums Ha ein planparalleler Deckel, der den Hohlraum Ha hermetisch abschließt. Die Öffnungen in der Membranschicht 4a sind vollständig mit der Glasschicht 5 gefüllt, der aus Membranschicht 3 und Abdeckschicht 5 bestehende Deckel D besitzt überall eine gleichmäßige Dicke. Auch im Bereich der Öffnungen 4a weist der Deckel D eine ebene Oberkante und eine ebene Unterkante auf. Über dem Hohlraum Hb besitzt der Deckel eine Öffnung mit verrundeten Seitenwänden, da die Schichtdicke y nicht ausreicht, um die Öffnung 4b zu verschließen.

Die mit dem erfindungsgemäßen Verfahren hergestellten mikromechanischen Bauteile bzw. Deckel mit oder ohne Öffnung lassen sich vorteilhaft bei folgenden beispielhaft aufgelisteten mikromechanischen Systemen, Sensoren bzw. Bauelementen einsetzen:
- Abdeckung (mechanischer Schutz) für Beschleunigungssensoren
- Abdeckschichten mit Öffnungen für hochauflösende Tintenspritzer
- Abdecken von Hohlräumen für fusible links
- Ausbilden von langen Kanälen für Gaschromatographen
- Ausbilden von Kanal-Netzwerken für Fluidics
- Ausbilden von Kühlkanälen bei integrierten Schaltungen mit hoher Verlustleistung an der Chipoberfläche (für Helium- oder H₂O-Kühlung)
- Ausbilden von Kapillaren
- Herstellen von Düsen und Düsen-Arrays mit Lochdurchmessern im Sub-µ-Bereich oder größer
- Herstellen von Lichtleitern (Wave Guides)
- Herstellen von Membranen für Resonatoren, Mikrophonen, Drucksensoren oder ähnlichem.

## Patentansprüche

1. Mikromechanisches Bauteil auf einem Substrat mit einem Hohlraum,
bei dem der Hohlraum (Ha,Hb) mit einem Deckel (D) versehen ist, der eine im wesentlichen gleichmäßige Dicke aufweist und eine Membranschicht (3) mit Öffnungen (4) und eine Abdeckschicht (5) aus einem dotierten Glas umfaßt.

2. Mikromechanisches Bauteil nach Anspruch 1,
bei dem der Deckel (D) planparallel ist.

3. Mikromechanisches Bauteil nach einem der Ansprüche 1 bis 2,
bei dem der Hohlraum (Ha) evakuiert ist.

4. Mikromechanisches Bauteil nach einem der Ansprüche 1 bis 2,
bei dem der Hohlraum (Ha, Hb) ein Gas oder eine Flüssigkeit enthält.

5. Mikromechanisches Bauteil nach einem der Ansprüche 1 bis 4,
bei dem der Hohlraum (Ha, Hb) eine bewegliche mikromechanische Struktur enthält.

6. Mikromechanisches Bauteil nach einem der Ansprüche 1 bis 5,
bei dem der Deckel (D) den Hohlraum (Ha) vollständig schließt.

7. Mikromechanisches Bauteil nach einem der Ansprüche 1 bis 5,
bei dem der Deckel (D) eine Öffnung aufweist.

8. Herstellverfahren für ein mikromechanisches Bauteil auf einem Substrat (1) mit folgenden Schritten:
- auf das Substrat (1) wird eine Hilfsschicht (2) und eine mit einer Öffnung (4a) versehene Membranschicht (3) aufgebracht,
- die Hilfsschicht (2) wird durch die Öffnung (4) hindurch selektiv zur Membranschicht (3) geätzt, so daß in der Hilfsschicht (2) ein Hohlraum (H) entsteht,
- es wird eine Abdeckschicht (5) aus einem dotiertem Glas in einer Dicke aufgebracht, die größer oder gleich einer vorgegebenen Grenzschichtdicke y_{G} ist,
- es wird ein Temperaturschritt durchgeführt, so daß der Hohlraum (Ha) mit einem Deckel (D) gleichmäßiger Dicke verschlossen wird.

9. Herstellverfahren für ein mikromechanisches Bauteil auf einem Substrat (1) mit folgenden Schritten:
- auf das Substrat (1) wird eine Hilfsschicht (2) und eine mit einer Öffnung (4b) versehene Membranschicht (3) aufgebracht,
- die Hilfsschicht (2) wird durch die Öffnung (4) hindurch selektiv zur Membranschicht (3) geätzt, so daß in der Hilfsschicht (2) ein Hohlraum (Hb) entsteht,
- es wird eine Abdeckschicht (5) aus einem dotierten Glas in einer Dicke aufgebracht, die kleiner einer vorgegebenen Grenzschichtdicke y_{G} ist,
- es wird ein Temperaturschritt durchgeführt, so daß über dem Hohlraum (Hb) ein Deckel mit einer Öffnung erzeugt wird, die einen geringeren Durchmesser aufweist als die Öffnung in der Membranschicht (3).

10. Herstellverfahren nach einem der Ansprüche 8 oder 9, bei dem der Hohlraum (Ha, Hb) mit einem Ätzprozeß mit isotroper Komponente hergestellt wird.

11. Mikrosystem mit einem mikromechanischen Bauteil nach einem der Ansprüche 1 bis 7 und einer damit verbundenen intergrierten Schaltung.
